# FASCICULE DE BREVET EUROPEEN

(11) **EP 0 491 596 B1**
(45) Date de publication et mention de la délivrance du brevet: **06.08.1997**
(21) Numéro de dépôt: 91403308.9
(22) Date de dépôt: 06.12.1991
(51) Int. Cl.: H01L 27/148, G01J 5/34

(54) **Détecteur infrarouge monolithique à matériau pyroélectrique**
Monolithischer Infrarotdetektor aus pyroelektrischem Material
Monolithic infrared detector of pyroelectric material

(30) Priorité: 11.12.1990 FR 9015476
(43) Date de publication de la demande: 24.06.1992
(73) Titulaire: THOMSON-CSF SEMICONDUCTEURS SPECIFIQUES, 75008 Paris (FR)
(72) Inventeur: Dautriche, Pierre, F-92045 Paris la Défense (FR)
(74) Mandataire: Guérin, Michel

(56) Documents cités:
- GB-A- 2 200 246
- US-A- 3 885 301
- US-A- 4 024 560
- SPIE, INFRARED DETECTORS AND ARRAYS vol. 930, 1988, pages 151 - 163; N. BUTLER ET AL.: 'AMBIENT TEMPERATURE SOLID STATE PYROELECTRIC IR IMAGING ARRAYS'
- FERROELECTRICS vol. 91, 1989, USA pages 127 - 139; M. OKUYAMA ET AL.: 'PYROELECTRIC IR-CCD IMAGE SENSOR'
- INFRARED PHYS. vol. 22, 1982, GB pages 259 - 275; R. WATTON ET AL.: 'THE PYROELECTRIC/CCD FOCAL PLANE HYBRIDE: ANALYSIS AND DESIGN FOR DIRECT CHARGE INJECTION'

## Description

L'invention concerne des détecteurs infrarouges, notamment matriciels, du type réalisé suivant une structure monolithique à l'aide de matériaux pyroélectriques.

Dans l'imagerie infrarouge, il est courant d'utiliser du matériau pyroélectrique pour réaliser la structure détectrice proprement dite, et de rapporter cette structure détectrice sur un multiplexeur à transfert de charge ou en abrégé CCD (de l'Anglais "Charge Coupled Device").

Le multiplexeur CCD est réalisé sur un substrat semiconducteur, séparément de la structure détectrice à base de matériaux pyroélectriques, de telle manière que l'ensemble détecteur infrarouge constitue une structure hybride.

De tels ensembles détecteurs infrarouges sont décrits dans le document de brevet GB-A-2 200 246 et dans l'article "Ambiant temperature solid state pyroelectric IR imaging arrays" de N. BUTLER, J Mc CLELLAND et S. IWASA, paru dans SPIE vol. 930, Infrared Detectors and Arrays, 1988, pages 151 à 163.

Ces ensembles détecteurs infrarouges sont généralement surfaciques, et permettent de réaliser une image comportant une pluralité de points élémentaires disposés en lignes et en colonnes. Ces points élémentaires appelés aussi pixels correspondent à un élément donné ou zone donnée du matériau pyroélectrique.

Généralement une couche de matériau absorbant le rayonnement infrarouge est en contact avec les éléments pyroélectriques. L'énergie thermique engendrée par la dissipation du rayonnement infrarouge est communiquée aux éléments pyroélectriques, lesquels produisent des charges électriques qui sont ainsi proportionnelles à l'intensité du rayonnement auquel a été soumis le pixel correspondant.

La lecture des quantités de charges appelée "charges de signal" engendrées par chacun des pixels, durant une phase d'exposition du détecteur, est effectuée à l'aide d'un circuit de lecture auquel toutes les différentes quantités de charges signal (ou des valeurs équivalentes) sont transférées successivement, à l'aide du multiplexeur CCD.

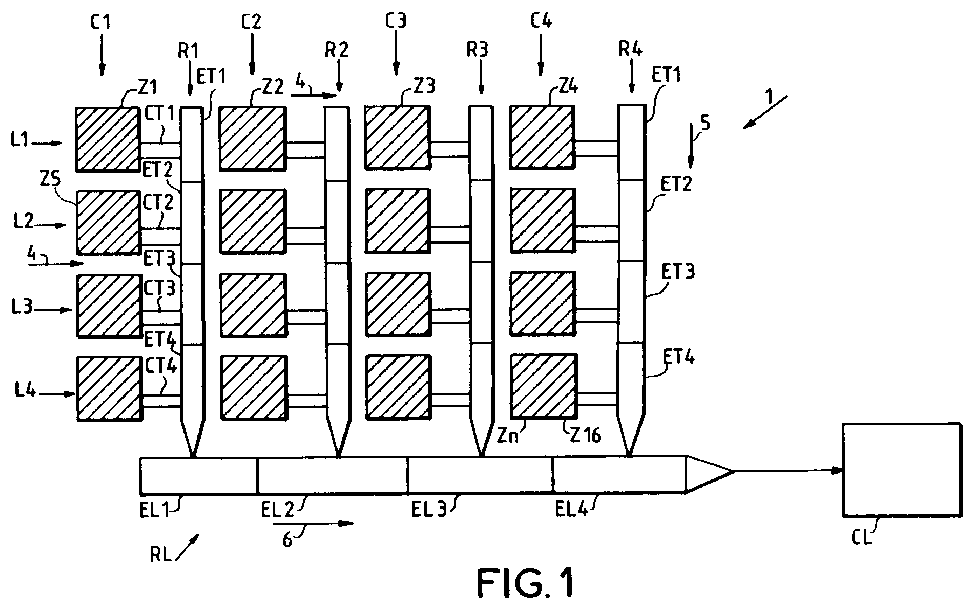

La figure 1 illustre schématiquement la manière dont s'opère le transfert des charges vers un circuit de lecture dans un ensemble détecteur infrarouge classique. L'ensemble détecteur comporte une surface détectrice formée n zones pyroélectriques Z1 à Zn (n étant égal à 16 dans l'exemple) disposées en lignes L1 à L4 et en colonnes C1 à C4. La surface détectrice est associée à un multiplexeur type CCD comportant autant de registres à décalage appelé registre colonnes qu'il y a de colonnes C1 à C4. Chaque registre colonne R1 à R4 comporte autant d'étages ET1 à ET4 qu'il y a de lignes L1 à L4, de telle manière qu'à chaque zone pyroélectrique Z1 à Zn ou pixel correspond un étage d'un registre colonne. Chaque zone pyroélectrique Z1 à Zn est reliée à l'étage correspondant d'un registre colonne à l'aide d'un circuit d'acquisition et de transfert de charges, appelé circuit intermédiaire de transfert CT1 à CTn. La fonction de chaque étage de transfert intermédiaire est de recueillir la charge signal (ou une quantité de charges proportionnelle à cette charge signal), et de la transférer dans l'étage ET1 à ET4 du registre colonnes R1 à R4 correspondant.

Il existe donc autant de circuits intermédiaires CT1 à CTn qu'il y a de zones pyroélectriques.

Suivant un fonctionnement courant, les charges de signal produites au niveau de chaque zone pyroélectrique Z1 à Zn (ou une valeur correspondante) sont transférées dans l'étage d'entrée du circuit de transfert intermédiaire, par lequel elles sont ensuite transférées vers l'étage de lecture ET1 à ET4 correspondant du registre R1 à R4. Ce transfert des charges est accompli suivant une première direction représentée par une flèche 4. Toutes les charges de signal étant chargées dans l'étage ET1 à ET4 d'un registre colonnes R1 à R4, ces registres colonnes sont actionnés pour transférer ces charges suivant le sens montré par la flèche 5, vers un étage de lecture EL1 à EL4 d'un autre registre à décalage appelé registre de lecture R L.

Chaque colonne C1 à C4, c'est-à-dire chaque registre colonnes, correspond à un étage de lecture EL1 à EL4 du registre de lecture RL. Ainsi par exemple, le premier pas de transfert des registres colonnes a pour effet de charger dans les étages de lecture EL1 à EL4, les charges ayant pour origine respectivement les zones pyroélectriques Z13, Z14, Z15, Z16.

Quand toutes ces charges sont contenues dans le registre de lecture RL, ce dernier est actionné à son tour pour transférer ces charges dans un circuit de lecture CL, qui en fait la lecture l'une après l'autre, et délivre pour chacune de ces charges un signal de sortie, généralement sous forme d'une tension proportionnelle à la valeur de chacune des quantités de charge. Ce fonctionnement est répété jusqu'à ce que les charges produites dans les pixels de la première ligne L1 soient à leur tour transférées, en parallèle, dans le registre de lecture RL, puis transférées par ce dernier dans le circuit de lecture CL.

De tels ensembles détecteurs infrarouges à structure hybride sont relativement difficiles à réaliser, et sont par suite d'un coût très élevé, du fait notamment des difficultés liées à l'assemblage de la structure détectrice avec la structure semiconductrice. Ainsi par exemple, dans certains cas, les zones pyroélectriques sont constituées par autant d'éléments séparés qu'il y a de points élémentaires d'images ou pixels. En outre ces éléments pyroélectriques doivent être portés par le substrat semiconducteur sur lequel est formé le multiplexeur CCD, par l'intermédiaire de plots électriquement conducteurs mais thermiquement isolants. L'utilisation de tels plots de liaison s'impose pour éviter que l'énergie thermique engendrée dans la surface absorbante du rayonnement infrarouge, ne soit communiquée au substrat semiconducteur, ce qui aurait pour conséquence de dégrader les caractéristiques de fonctionnement du multiplexeur CCD.

Une autre forme de réalisation est décrite dans l'article de M. OKUYAMA et al. "PYROELECTRIC IR-CCD IMAGE SENSOR", publié dans Ferroelectrics, 1989, vol. 91, pages 127 - 139. Ce document décrit un détecteur infrarouge dans lequel une structure détectrice à base de matériau pyroélectrique est rapportée sur le multiplexeur CCD c'est-à-dire sur le substrat semiconducteur, par l'intermédiaire d'une couche diélectrique qui assure l'isolation thermique.

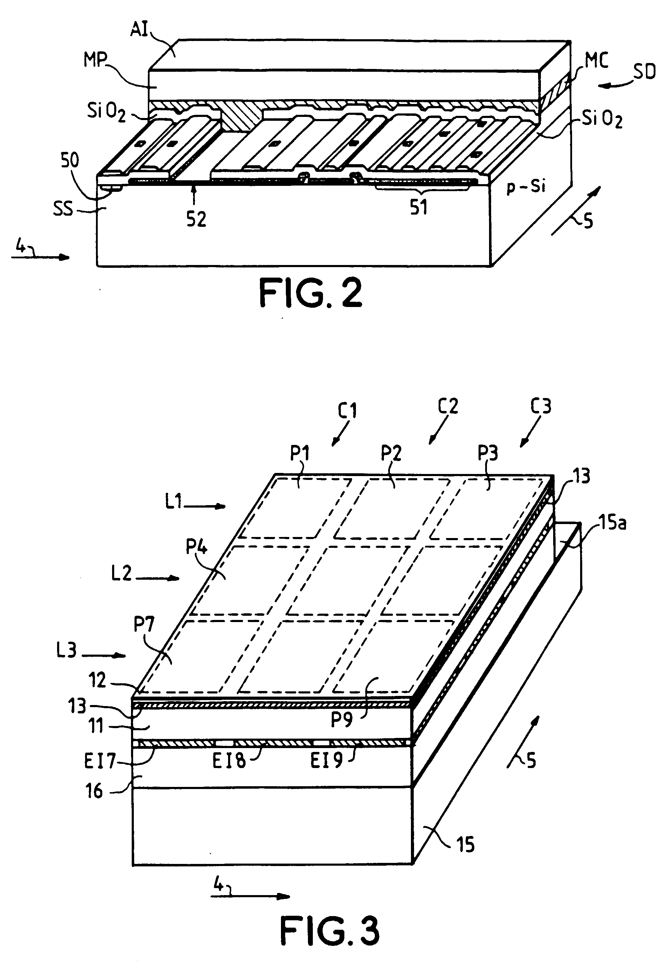

La figure 2 est une vue en perspective avec une coupe partielle. Cette figure reproduit une figure du document ci-dessus cité, montrant la structure détectrice à base de matériau pyroélectrique, rapportée sur un substrat semiconducteur par l'intermédiaire d'une couche diélectrique de couplage ; cette dernière réalisant une isolation thermique entre le substrat et la structure détectrice.

Sur la figure 2, le substrat semiconducteur SS porte une succession d'électrodes qui constitue un circuit intermédiaire de transfert tel que ceux mentionnés en référence à la figure 1. D'une manière semblable à celle déjà expliquée en référence à la figure 1, à partir d'une électrode d'injection repérée 50, les charges sont transférées suivant le sens de transfert montré par la flèche 4, en direction d'un étage de registre colonnes (à quatre phases) représenté par les quatre électrodes repérées 51. Comme dans l'exemple de la figure 1, le sens de transfert 4 est parallèle aux lignes de pixel : c'est-à-dire que la succession d'électrodes montrée à la figure 2 se rapporte à un unique pixel, mais qu'en fait de telles successions d'électrodes se répètent à gauche et à droite, et aussi en profondeur dans le sens des colonnes, pour former un détecteur complet. La quantité de charges transférée vers l'étage 51 du registre colonne est contrôlée au niveau repéré 52 qui constitue l'étage d'entrée. Ces charges sont ensuite à transférer suivant le sens montré par la flèche 5, pour être chargées dans un étage de registre de lecture (non visible sur la figure 2) semblable à celui décrit en référence à la figure 1.

Le substrat semiconducteur SS, et la succession d'électrodes répétée suivant le sens des lignes, et aussi orthogonalement à ces dernières suivant le sens des colonnes, constituent la partie multiplexeur CCD, sur laquelle est posée la structure détectrice SD.

La structure détectrice comprend une couche de matériau pyroélectrique MP, elle-même recouverte d'une couche AI destinée à absorber le rayonnement infrarouge. Dans cette réalisation, les zones pyroélectriques ou pixels sont matérialisées par des électrodes métalliques (non montrées sur la figure 2) formées sur la couche de matériau pyroélectrique, du côté du substrat semiconducteur. La structure détectrice n'est pas en contact avec les électrodes du multiplexeur CCD, dont elle est isolée électriquement et thermiquement par une couche d'un matériau diélectrique de couplage MC et par une couche isolante en Si 0₂ ; la couche de couplage MC étant en contact du matériau pyroélectrique et la couche isolante étant en contact des électrodes. Il est à noter que le couplage entre la structure détectrice et le multiplexeur CCD est rendu plus important au niveau de l'étage d'entrée 52, par le fait que la couche isolante en Si0₂ est interrompue au niveau de cet étage d'entrée pour laisser la place à la couche diélectrique de couplage MC.

Une telle forme de réalisation présente un progrès, notamment en ce qu'elle n'exige pas de d'utiliser des plots électriquement conducteurs et isolants thermique, entre le substrat semiconducteur et chaque zone pyroélectrique correspondant à un pixel. Cependant bien qu'intéressante, cette réalisation présente toujours les inconvénients attachés aux structures de types hybrides, car en effet, le multiplexeur CCD d'une part et la structure détectrice d'autre part sont réalisés séparément.

Une amélioration beaucoup plus marquante des détecteurs infrarouges à base de matériau pyroélectrique, résulte de l'utilisation de matériaux pyroélectriques possédant de faibles conductivités thermiques k, par exemple inférieures à 1 W/mK. Une telle utilisation de matériaux pyroélectriques à faibles conductivités thermiques est décrite dans une demande de brevet français FR-A-2 649 247. Ce document indique que l'on peut utiliser des polymères (pour lesquels généralement k est inférieur à 0,2 W/mK) tels que :
- le polyfluorure de vinylidène (PVDF),
- le polyfluorure de vinylidène - trifluoroéthylène (PVDF-TrFE),
- le polyfluorure de vinylidène - vinylacétate (PVDCN-VAc),
- le polycyanure de vinylidène - fluorure de vinylidène (PVDCN - VDF).

On peut généralement utiliser des matériaux composites (pour lesquels K < 1 W/mK) tels que des composés de charges minérales de grande conductivité thermique mélangées dans une matrice polymère de faible conductivité thermique. Par exemple, 60 % en poids de PZT dans du polyimide donne un coefficient K d'environ 0,9 W/mK.

L'avantage d'un tel matériau pyroélectrique à faible conductivité thermique, réside en ce qu'il peut constituer la surface détectrice par une couche sensiblement uniforme pouvant être réalisée ou déposée sur le substrat semiconducteur portant déjà le multiplexeur CCD. En fait on réalise la couche pyroélectrique sur des électrodes dont la superficie et la position définissent sensiblement la superficie et la position d'une zone pyroélectrique correspondant à un pixel.

Chacune de ces électrodes, appelée dans la suite de la description "électrode inférieure", constitue ainsi l'une des armatures d'une capacité pyroélectrique à laquelle peut être assimilée chaque pixel ou zone pyroélectrique ; l'autre armature de la capacité pyroélectrique peut être constituée sur l'autre face de la couche pyroélectrique, par exemple par une couche électriquement conductrice formant une électrode appelée électrode supérieure et qui est commune à toutes les zones pyroélectriques.

On réalise ainsi des ensembles détecteurs infrarouges à base de matériau pyroélectrique, ayant une structure monolithique, et dont la fabrication est alors considérablement simplifiée.

Par rapport à la structure hybride montrée à la figure 2, un tel détecteur infrarouge monolithique peut comporter un même substrat semiconducteur et une succession semblable d'électrodes, de manière à constituer un multiplexeur CCD semblable à celui de la figure 2. D'autre part, la couche de matériau pyroélectrique à faible conductivité thermique bien que réalisée ou déposée sur le multiplexeur CCD, peut se présenter d'une manière semblable à celle de la couche pyroélectrique de la figure 2 ; à la différence cependant que dans la réalisation de type hybride, la couche de matériau pyroélectrique repose sur le substrat semiconducteur par l'intermédiaire d'une couche diélectrique de couplage MP, alors que dans le cas de la structure monolithique la couche de couplage MP est remplacée par une couche électriquement conductrice destinée à former l'électrode inférieure ci-dessus mentionnée.

Cependant, dans le cas du détecteur infrarouge monolithique ayant une couche de matériau pyroélectrique à faible conductivité thermique, cette couche étant directement réalisée sur le substrat semiconducteur, il est nécessaire de la soumettre à une opération dite "de polarisation", destinée à réaliser l'orientation cristalline. Cette polarisation consiste à appliquer entre les deux électrodes de chaque capacité pyroélectrique ou zone pyroélectrique, une tension électrique ayant la polarité convenable et une amplitude qui peut atteindre par exemple 1000 volts pour 10 micromètres de l'épaisseur du matériau pyroélectrique.

La polarisation du matériau pyroélectrique, dans le cadre d'un détecteur infrarouge monolithique, présente l'inconvénient de n'être pas très simple à réaliser, du fait qu'elle exige d'accéder à toutes les électrodes inférieures de toutes les capacités pyroélectriques. A cet effet, il est possible par exemple à l'aide des techniques classiques de microlithographie, de relier toutes les électrodes inférieures entre elles et à une électrode extérieure, puis d'appliquer la tension de polarisation entre cette électrode extérieure et l'électrode supérieure précédemment mentionnée ; puis ensuite par les techniques de microlithographie, de supprimer les connexions entre toutes ces électrodes inférieures en vue de permettre le fonctionnement normal de toutes les capacités pyroélectriques.

Cette solution est certes réalisable, mais elle est longue, délicate, et par conséquent coûteuse.

Un autre problème attaché au détecteur infrarouge de type monolithique tient au fait que, par rapport aux autres matériaux pyroélectriques, pour une même énergie thermique, la quantité de charges électriques produites par les matériaux pyroélectriques à faible conductivité thermique est nettement plus faible, et par suite ne permet pas d'obtenir une aussi bonne résolution thermique.

L'invention s'applique aux détecteurs infrarouges à base de matériaux pyroélectriques de type monolithique, c'est-à-dire du type dans lequel la couche pyroélectrique est formée sur le substrat semiconducteur, et elle s'applique particulièrement (mais non exclusivement) dans le cas des matériaux pyroélectriques à faible coefficient de conductivité thermique. Elle a pour but de faciliter l'opération de polarisation du matériau pyroélectrique. Elle permet en outre de remédier aux problèmes de la résolution thermique, problèmes posés notamment dans le cas des matériaux pyroélectriques à faible conductivité thermique, du fait de leur faible coefficient de réponse.

Selon l'invention, un détecteur infrarouge de type monolithique, comportant :
- un substrat semiconducteur comprenant un circuit multiplexeur à transfert de charge ;
- une couche de matériau pyroélectrique formée sur le substrat semiconducteur et comprenant une pluralité de zones pyroélectriques, chaque zone pyroélectrique correspondant à un pixel et comportant une électrode inférieure individuelle reliée électriquement à un étage d'entrée correspondant du circuit multiplexeur à transfert de charge ;
- une couche conductrice formant une électrode supérieure portée par la couche de matériau pyroélectrique à l'opposé des électrodes inférieures, l'électrode supérieure étant commune à toutes les zones pyroélectriques ; et
- des moyens de commutation reliant respectivement les électrodes inférieures au substrat semiconducteur afin de permettre l'établissement d'un courant électrique entre chaque électrode inférieure et le substrat semiconducteur pour polariser la couche de matériau pyroélectrique.

L'invention concerne également un procédé de lecture de charges de signal tel que défini dans la revendication 7.

L'invention sera mieux comprise à la lecture de la description qui suit, faite à titre d'exemple non limitatif en référence aux figures annexées, parmi lesquelles :
- la figure 1 déjà décrite illustre le fonctionnement d'une structure détectrice associée à un multiplexeur CCD ;
- la figure 2 déjà décrite représente un détecteur infrarouge de type hybride suivant l'art antérieur ;
- la figure 3 est une vue en perspective qui montre l'organisation générale d'un détecteur infrarouge à base d'un matériau pyroélectrique, de type monolithique conformément à l'invention ;
- la figure 4 représente de manière schématique les éléments d'un pixel déjà montré à la figure 3, suivant un agencement conforme à l'invention ;
- la figure 5a est un schéma électrique des éléments représentés à la figure 4 ;
- la figure 5b est à lire en relation avec la figure 5a, et représente des puits de potentiel créés dans un substrat semiconducteur.

La figure 3 représente l'organisation générale d'un détecteur infrarouge 10 suivant l'invention.

Le détecteur infrarouge comporte une couche pyroélectrique 11 du type à faible coefficient de conductivité thermique.

La couche pyroélectrique 11 est rendue sensible au rayonnement infrarouge à l'aide d'une couche 12 d'un matériau absorbant l'infrarouge, en lui-même classique. La couche pyroélectrique 11 est revêtue d'une couche électriquement conductrice 13, qui constitue une électrode appelée dans la suite de la description électrode supérieure 13.

La couche absorbante 12 est disposée au dessus de l'électrode supérieure 13 et en contact avec cette dernière, de manière que l'énergie thermique engendrée par le rayonnement infrarouge soit appliquée à la couche pyroélectrique 11.

La couche pyroélectrique 11 est partagée en une pluralité de zones élémentaires ou pixels P1 à P9 disposés en ligne L1 à L3 et en colonnes C1 à C3.

Dans l'exemple non limitatif décrit, et pour simplifier la description, seulement trois colonnes C1 à C3 et trois lignes L1 à L3 sont représentées, formant neuf pixels ; mais ces lignes et colonnes peuvent être en nombres différents, beaucoup plus grands ou même plus faibles de manière par exemple à comporter une unique ligne ou colonne afin de constituer une barrette.

La couche 11 de matériau pyroélectrique est formée d'une couche uniforme et dans l'exemple non limitatif décrit, les pixels P1 à P9 sont définis chacun à l'aide d'une électrode dite électrode inférieure EI 1 à EI 9 dont la position et la dimension définissent la position et la dimension du pixel. Ces électrodes inférieures sont disposées sur une face de la couche pyroélectrique 11 à l'opposé de l'électrode supérieure 13, et dans l'exemple de la figure 3, seulement trois électrodes inférieures EI 7, EI 8, EI 9 sont représentées, qui correspondent respectivement aux pixels P7, P8, P9.

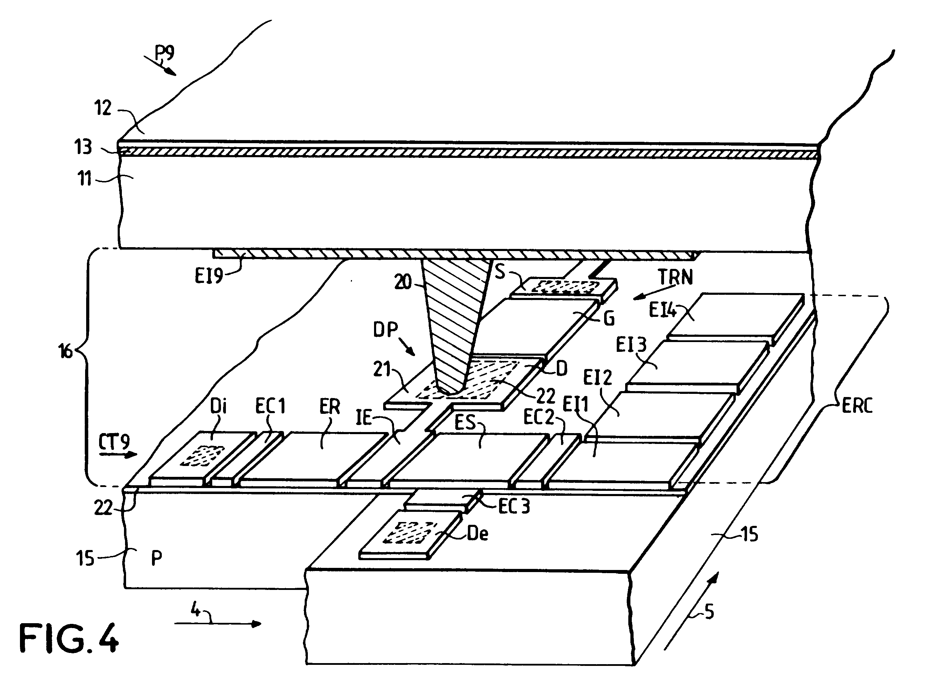

La couche pyroélectrique 11 est réalisée sur un substrat semiconducteur 15, et dans l'exemple non limitatif de la description elle est séparée de ce dernier par une couche 16 électriquement isolante relativement épaisse (de l'ordre par exemple de 10 micromètres), par exemple en polymide. Comme il sera davantage expliqué en référence à la figure 4, la couche isolante 16 a pour fonction de réduire le couplage entre la couche pyroélectrique 11 et certaines électrodes (non représentées sur la figure 3) que comporte le substrat 15 pour former un multiplexeur CCD. Mais bien entendu dans l'esprit de l'invention, la couche pyroélectrique 11 peut être déposée ou réalisée directement sur le substrat 15 ou par l'intermédiaire d'une couche électriquement isolante peu épaisse, en oxyde de silicium par exemple.

La couche 11 de matériau pyroélectrique est d'un type tel que cité dans le préambule, afin de présenter une faible conductivité thermique. Le dépôt de la couche pyroélectrique peut être réalisé par exemple par centrifugation d'une solution de polymères dans un solvant, suivant notamment une méthode connue sous le nom "méthode de la tournette".

Il est possible de déposer plusieurs couches de polymères pyroélectriques pour réaliser la couche 11, qui peut ainsi facilement avoir une épaisseur comprise entre 5 et 60 micromètres, par exemple.

L'électrode supérieure 13 peut ensuite être réalisée par exemple en déposant sur la couche pyroélectrique 11, une couche d'aluminium, par évaporation sous vide par exemple.

La couche d'absorbant infrarouge 12 est ensuite déposée, par exemple du noir d'aluminium par évaporation d'aluminium suivant une technique classique.

Ainsi qu'il sera davantage expliqué en référence à la figure 4, la polarisation du matériau pyroélectrique formant la couche 11, peut être effectuée dès qu'est réalisée l'électrode supérieure 13 qui est commune à tous les pixels P1 à P9.

L'énergie thermique engendrée par le rayonnement infrarouge durant une période d'exposition engendre des charges dans la couche de matériau pyroélectrique. Pour chaque pixel P1 à P9, les charges engendrées en fonction du rayonnement infrarouges sont collectées par une électrode inférieure EI 1 à EI 9. Chaque électrode inférieure est reliée à un étage d'entrée (non représenté) d'un circuit de transfert intermédiaire (dont la fonction est semblable à ceux mentionnés dans le préambule). Dès que la période d'exposition au rayonnement infrarouge est terminée, ces charges appelées charges de signal sont transférées, suivant le sens de transfert 4, pour être chargées dans un étage d'un registre colonnes (non représenté) ; elles sont ensuite transférées de façon en elle-même classique par les registres colonnes suivant le sens de transfert 5, vers un registre de lecture puis vers un circuit de lecture.

Les différents circuits intermédiaires de transfert, les différents registres colonnes, le registre de lecture et le circuit de lecture constituent un multiplexeur CCD (non représenté) formé de façon classique sur le substrat semiconducteur 15 ; le registre de lecture et le circuit de lecture sont symbolisés sur la figure par une zone 15a du substrat semiconducteur 15.

La figure 4 est une vue en perspective qui montre plus en détail les éléments relatifs à une unique zone pyroélectrique ou pixel, le pixel P 9 par exemple. Sur la figure 4, on n'a pas représenté la couche isolante 16, c'est-à-dire qu'elle n'apparaît pas à l'emplacement qui lui est réservé, afin de libérer et montrer la face supérieure du substrat 15, et représenter un agencement d'électrodes conforme à l'invention.

L'électrode inférieure EI 9 détermine dans la couche pyroélectrique 11 une zone pyroélectrique spécifique au neuvième pixel P9. L'électrode inférieure EI 9 est reliée par une métallisation verticale 20, à une électrode d'entrée IE d'un étage d'entrée appartenant à un circuit intermédiaire de transfert CT 9, réalisé sur le substrat semiconducteur 15. La métallisation verticale 20 correspond par exemple à un trou réalisé dans la couche isolante 16. Cette métallisation aboutit à un conducteur 21 relié à l'électrode d'entrée IE et qui est formé à la surface du substrat semiconducteur 15, plus précisément sur une couche isolante 22 en oxyde de silicium par exemple, qui de façon en elle-même classique réalise l'isolation électrique entre les différentes électrodes et le substrat semiconducteur 15.

L'électrode inférieure EI 9 est reliée à l'électrode d'entrée IE, et les charges de signal (où des quantités de charges proportionnelles à ces charges de signal) sont transférées par le circuit intermédiaire de transfert CT 9, suivant le sens de transfert 4.

Dans l'exemple non limitatif décrit, le circuit de transfert intermédiaire CT 9 comporte les éléments suivants, énumérés de la gauche de la figure 4 vers la droite, c'est-à-dire suivant le sens de transfert 4 :
- Une diode d'injection de charge Di, en elle-même classique : elle est constituée dans le substrat semiconducteur 15 à l'aide d'une implantation (représentée par un rectangle hachurée, en traits pointillés) d'un type de conductivité opposé à celui du substrat semiconducteur ; le substrat semiconducteur 15 étant dopé par exemple du type P, l'implantation est du type N, avec du phosphore par exemple.
- On trouve ensuite une électrode de commande EC1 destinée à autoriser le passage des charges produites par la diode d'injection Di ;
- l'électrode de commande EC 1 est suivie d'une électrode dite "de référence ER" ;
- On trouve ensuite l'électrode d'entrée IE de l'étage d'entrée ;
- Puis on trouve une électrode dite électrode de stockage ES qui représente un étage de stockage.
- L'électrode de stockage ES est suivie d'une seconde électrode de commande EC2 autorisant le passage de charges stockées dans l'étage de stockage ES.
- On trouve ensuite un étage ERC d'un registre colonne destiné à transférer les charges provenant de l'étage de stockage ; ce transfert est opéré suivant le sens des transferts 5, suivant un mode de fonctionnement qui a été expliqué précédemment dans le préambule à propos des registres dits "registres colonnes" utilisés dans les multiplexeurs CCD.

Dans l'exemple non limitatif décrit l'étage ERC appartient à un registre colonne du type à quatre phases, c'est-à-dire que chacun de ses étages et notamment l'étage ERC, comporte quatre étages intermédiaires EI 1, EI 2, EI 3, EI 4, qui pour le transfert des charges sont actionnés par des signaux de commande de transfert (non représentés) ayant des phases différentes, de façon à engendrer sous chacune des électrodes intermédiaires, une succession de puits et de barrière de potentiel ; cette succession étant appropriée à réaliser le transfert des charges dans le sens montré par la flèche 5.

En l'absence de ces signaux de commande de transfert, les charges provenant de l'étage de stockage ES peuvent être stockées par exemple dans le premier étage intermédiaire EI 1.

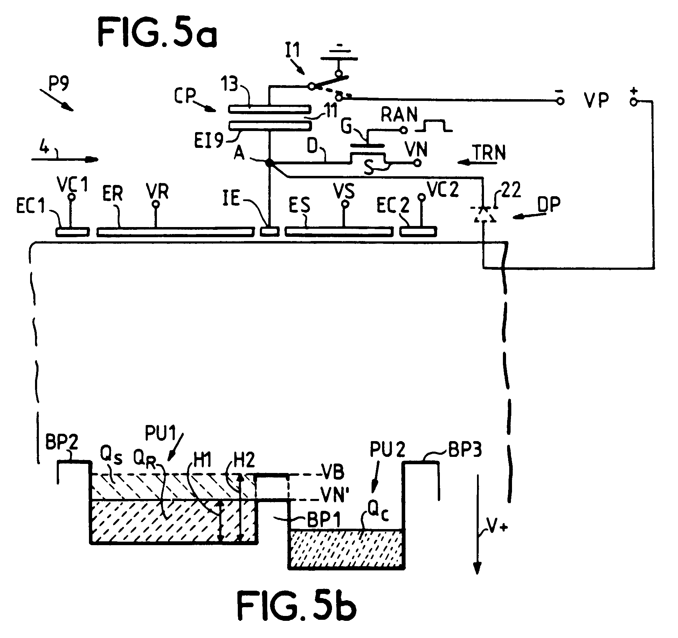

Il est à noter que l'étage de transfert intermédiaire CT 9 comporte en outre, une diode d'évacuation de charges De, et une troisième électrode de commande EC3, disposées au même niveau que l'étage de stockage ES. Cette diode d'évacuation De peut être constituée d'une même manière que la diode d'injection Di, et sa fonction est d'éliminer ou évacuer dans certains cas, des charges contenues dans un puits de potentiel de l'étage de stockage, ainsi qu'il est davantage expliqué dans une suite de la description faite en référence aux figures 5a et 5b. La troisième électrode de commande EC3 est destinée à autoriser le passage des charges depuis l'étage de stockage vers la diode d'évacuation De.

Suivant une caractéristique de l'invention, l'électrode inférieure Ei 9 est électriquement reliée au substrat semiconducteur 15 par l'intermédiaire d'un moyen de commutation qui permet le passage d'un courant électrique entre le substrat semiconducteur et l'électrode inférieure EI 9.

Dans l'exemple non limitatif décrit, ce moyen de commutation est une diode DP appelée diode de polarisation, réalisée par une implantation 22 (représentée par un rectangle hachurée en traits pointillés) d'un matériau présentant un type de conductivité (N) opposé à celui du substrat semiconducteur, par exemple du phosphore.

Le conducteur 21 sur lequel aboutit la métallisation verticale 20, est situé au dessus de l'implantation 22 servant à former la diode de polarisation DP, de façon à relier électriquement la diode DP à l'électrode inférieure EI 9.

Ceci réalise une liaison électrique entre le substrat semiconducteur 15 et l'électrode inférieure EI 9, liaison qui permet le passage du courant dans uniquement un sens.

Dans l'exemple non limitatif décrit où la conductivité du substrat semiconducteur 15 est du type P, et l'implantation 22 est du type N, cette implantation constitue la cathode de la diode de polarisation DP, et un courant peut passer à travers cette diode si le substrat semiconducteur est porté à un potentiel positif par rapport à celui de l'électrode inférieure EI 9.

La diode de polarisation DP est destinée à permettre la polarisation du matériau pyroélectrique qui constitue le neuvième pixel P9. Cette polarisation peut ainsi être accomplie de façon très simple, en appliquant une tension électrique de l'ordre de 1000 volts par exemple entre le substrat semiconducteur 15 et l'électrode supérieure 13, avec le potentiel positif au substrat semiconducteur. Toutes les électrodes inférieures EI 1 à EI 9 de tous les pixels P1 à P9 étant également reliées au substrat semiconducteur 15 par une diode de polarisation semblable à celle montrée en figure 4, et l'électrode supérieure 13 étant commune à tous les pixels P1 à P9, la polarisation de tous les pixels peut être réalisée par une même opération.

La présence de la diode de polarisation DP peut perturber le fonctionnement, durant la période d'exposition où des charges sont engendrées dans le matériau pyroélectrique sous l'action d'une énergie thermique.

En vue notamment de remédier à cet inconvénient, et suivant une autre caractéristique de l'invention, l'électrode inférieure EI 9 et par suite l'électrode d'entrée IE et l'implantation 22 formant la cathode de la diode DP, sont reliées à un second moyen de commutation dont le fonctionnement est expliqué dans une suite de la description relative aux figures 5a et 5b.

Dans l'exemple non limitatif décrit, le second moyen de commutation est un transistor de type "MOS" qui est appelé transistor de remise à niveau TRN.

Le transistor TRN est réalisé dans le substrat semiconducteur 15 d'une façon en elle-même classique, par exemple l'aide d'une implantation de type N pour former la source S, et une autre implantation de type N pour former le drain D ; la conduction dans l'espace formé entre le drain D et la source S est contrôlée par une électrode qui constitue la grille G du transistor TRN. Ce dernier a une fonction de commutation, et l'une de ses extrémités, le drain D par exemple, est reliée électriquement à l'électrode d'entrée IE, à l'électrode inférieure EI 9, et la cathode de la diode DP.

A cette fin dans l'exemple non limitatif décrit, l'implantation 22 de type N qui constitue la cathode de la diode DP, constitue également le drain D du transistor TRN.

Pour plus de clarté de la figure 4, on n'a pas représenté les conducteurs en eux-mêmes classiques qui servent à véhiculer les différents signaux et les différentes tensions nécessaires au fonctionnement, lesquels signaux et tensions seront expliqués en référence aux figures 5a et 5b.

Bien entendu, d'autres positions relatives peuvent être conférées aux différents éléments qui dans la figure 4 sont rapportés sur le substrat semiconducteur 15, l'important étant d'une part, qu'un moyen de commutation (DP) soit réalisé, du type diode ou transistor ou interrupteur, ou même relais, moyen qui permet la circulation d'un courant entre le substrat semiconducteur 15 et l'électrode inférieure EI 9 ; et d'autre part qu'un second moyen de commutation (TRN) puisse être commandé, durant certaines séquences du fonctionnement, pour appliquer à l'électrode inférieure EI 9 (et les éléments qui lui sont connectés) un niveau de tension déterminé. Il est à noter en outre que la couche électriquement isolante 16 qui sépare l'électrode inférieure EI 9 et le substrat semiconducteur, peut comporter une épaisseur non négligeable comme dans l'exemple montré à la figure 4, par exemple une épaisseur de l'ordre 20 micromètres, afin de réduire le couplage entre l'électrode inférieure EI 9 et les différentes électrodes formées sur le substrat semiconducteur. Dans l'esprit de l'invention cependant, l'épaisseur de la couche isolante 16 pourrait être réduite à une valeur suffisante à assurer l'isolement électrique, par exemple de l'ordre de 1 micromètre.

La figure 5a est un schéma électrique des éléments montrés à la figure 4, laquelle est relative au pixel P9. Mais bien entendu, ce schéma électrique s'applique également à tous les autres pixels P1 à P8.

Sur la figure 5a, la diode de polarisation DP, est représentée en traits pointillés dans le substrat semiconducteur 15, et sa cathode (22) est reliée à un point de connexion A commun à l'électrode d'entrée IE, au drain D du transistor TRN de remise à niveau, et à l'électrode inférieure EI 9. L'électrode inférieure EI 9 et l'électrode supérieure sont représentées comme les armatures d'une capacité CP, dite capacité pyroélectrique, dont le diélectrique est constitué par le matériau pyroélectrique formant le pixel P9.

Comme il a été dit précédemment, la diode de polarisation DP permet le passage d'un courant entre le substrat semiconducteur 15 et l'électrode inférieure, afin de réaliser la polarisation du matériau pyroélectrique. A cette fin, il suffit d'appliquer, avec la polarité compatible avec le sens de conduction de la diode de polarisation DP, une tension de polarisation VP. Dans l'exemple représenté à la figure 5, la polarité négative - VP est appliquée à l'électrode supérieure 13, et la polarité positive + VP est appliquée au substrat semiconducteur 15, ainsi qu'à l'électrode inférieure EI 9 où elle est diminuée de la chute de tension dûe au seuil de la diode de polarisation DP.

Pour une meilleure compréhension, sur la figure 5a, l'alimentation en tension de l'électrode supérieure 13 est réalisée par l'intermédiaire d'un élément de commutation I1 à deux positions, dont l'une correspond à l'application du potentiel négatif de la tension de polarisation VP, et l'autre correspond à l'application d'un potentiel sensiblement égal à celui du substrat 15. Mais en pratique, la polarisation du matériau pyroélectrique se situe à un stade qui précède celui du fonctionnement, et il n'est donc pas nécessaire de prévoir un tel commutateur.

En fonctionnement, la diode de polarisation DP peut fausser les mesures, en ce qu'elle peut écouler les charges engendrées dans la capacité pyroélectrique CP, charges qui sont collectées par l'électrode inférieure EI 9. En effet, l'accumulation des charges négatives sur l'électrode inférieure EI 9 a pour effet de produire une variation négative du potentiel de cette dernière. Aussi, si la différence de potentiel entre le substrat semiconducteur et l'électrode inférieure atteint le seuil de conduction de la diode de polarisation DP, celle-ci écoule les charges vers le substrat 15.

Dans la présente invention, cet inconvénient est évité à l'aide du transistor TRN de remise à niveau. La source S de ce dernier est reliée au potentiel positif d'un tension VN, appelée tension de remise à niveau. En pratique la tension de remise à niveau VN peut avoir une valeur de l'ordre de 5 à 6 volts, par exemple, par rapport au potentiel du substrat semiconducteur 15.

Le substrat semiconducteur 15 et l'électrode supérieure sont reliés à un même potentiel, le potentiel de la masse par exemple. Dans ces conditions, on applique à la grille de commande G du transistor TRN un signal de commande de remise à niveau RAN, consistant par exemple en un créneau de tension pendant la durée duquel le transistor TRN est rendu conducteur :
- par suite la tension de remise à niveau est appliquée à l'électrode inférieure EI 9, ce qui a pour effet de charger la capacité pyroélectrique CP à la valeur de la tension de remise à niveau VN (côté électrode inférieure EI 9), l'autre armature (électrode supérieure 13) de la capacité pyroélectrique CP et le substrat semiconducteur 15 étant à la masse, la diode de polarisation DP est à l'état bloquée.

Bien entendu, pendant que le transistor de remise à niveau TRN est conducteur c'est-à-dire pendant la phase de remise à niveau, aucune charge n'est accumulée dans la capacité pyroélectrique CP.

Le fonctionnement du détecteur infrarouge peut être par exemple tel que la commande de remise à niveau, appliquée à la grille G du transistor TRN, cesse un peu avant l'instant où débute l'exposition des pixels à un rayonnement : avec la fin du signal de commande de remise à niveau, le transistor de remise à niveau TRN passe de l'état conducteur à l'état bloqué, et en conséquence le point de connexion A commun à l'électrode inférieure EI 9 et l'électrode d'entrée IE et la cathode de la diode de polarisation DP, constitue un point à potentiel flottant. Si des charges sont créées dans la capacité pyroélectrique CP (qui représente la zone pyroélectrique du pixel P9) quand le transistor de remise à niveau TRN est non conducteur, c'est-à-dire quand le point A est à potentiel flottant, ces charges entraînent une variation négative du potentiel du point A, potentiel qui partant de la valeur positive de la tension de remise à niveau VN tend à diminuer et à se rapprocher du potentiel de la masse, c'est-à-dire du potentiel du substrat semiconducteur 15.

En conséquence la diode de polarisation DP est bloquée tant que le point à potentiel flottant A est à un potentiel plus positif ou égal à celui du substrat semiconducteur 15 ; de telle manière que la diode de polarisation DP ne perturbe en rien l'accumulation des charges qui constituent les charges de signal.

Le fonctionnement décrit ci-dessus correspond à une acquisition ou lecture des charges de signal suivant un mode appelé "lecture en tension".

D'une façon classique, la lecture des charges de signal se fait suivant deux modes principaux dont l'un est la lecture dite en charge, et l'autre est la lecture en tension.

Le principe de la lecture en charge est décrit de façon très détaillée dans l'article de R. WATTON et al. "The pyroelectric/CCD focal plane hybrid : Analysis and design for direct charge injection", publié dans Infrared Phys. vol. 22, pages 259 à 275, 1982.

La lecture en charge consiste à injecter directement les charges dans un registre à décalage type CCD. La capacité pyroélectrique est remise à niveau après chaque lecture.

Dans la méthode de lecture en tension, on utilise la tension de la capacité pyroélectrique pour moduler une grille ou électrode d'un étage CCD. La modulation de la tension de cette électrode provoque une modulation de la hauteur d'une barrière de potentiel dans le substrat. La capacité pyroélectrique peut ensuite être déchargée à l'aide d'un dispositif "chopper", qui permet d'interposer un écran absorbant entre la source du rayonnement infrarouge et le détecteur infrarouge en dehors des périodes d'exposition, de telle sorte qu' aucune énergie thermique n'étant transmise au matériau pyroélectrique, ce dernier recouvre la température qu'il comportait avant la période d'exposition au rayonnement.

La méthode de lecture en tension présente l'avantage de conférer à l'ensemble détecteur un rapport signal sur bruit beaucoup plus fort que la méthode de lecture en charge, et donc d'obtenir une meilleure résolution thermique. Ceci particulièrement si on élimine les charges accumulées dans la capacité pyroélectrique pendant l'exposition au rayonnement, en laissant le matériau pyroélectrique retourner à sa température initiale (à l'aide d'un dispositif chopper), et non en appliquant à la capacité pyroélectrique une tension de remise à niveau à l'aide d'un moyen de commutation susceptible d'engendrer un bruit important.

Dans la présente invention la lecture est du type "en tension", et elle est accomplie suivant une méthode dite différentielle, qui tend à supprimer le bruit de remise à niveau produit par le moyen de commutation que constitue le transistor TRN.

Le début d'un cycle de fonctionnement peut consister dans une remise à niveau de la capacité pyroélectrique CP. A cet effet, comme il a été précédemment expliqué, le transistor TRN de remise à niveau est rendu conducteur, et la tension positive de remise à niveau VN est appliquée au point A, et donc à l'électrode d'entrée IE. Dans le même temps, l'électrode de référence ER et l'électrode de stockage ES reçoivent respectivement une tension de référence VR et une tension dite de stockage VS, ces tensions de référence et de stockage VR et VS étant plus positives que la tension de remise à niveau VN.

D'autre part la première et la seconde électrode de commande EC1, EC2 reçoivent des tensions de commandes respectivement VC1, VC2 plus négatives que la tension de remise à niveau VN. Il en résulte dans le substrat semiconducteur 15, des puits et des barrières de potentiel qui sont illustrés sur la figure 5b.

La figure 5b montre les puits de potentiel et les barrières de potentiel engendrés dans le substrat semiconducteur 15, par l'application des tensions ci-dessus énumérées ; sur la figure 5b une flèche V⁺ symbolise le fait que les potentiels positifs vont en croissant vers le bas, suivant une représentation courante dans le domaine des circuits à transfert de charge.

L'électrode d'entrée IE étant plus négative que les électrodes de référence et de stockage ER, ES, une barrière de potentiel BP1 est réalisée sous l'électrode d'entrée IE. Cette barrière de potentiel sépare deux puits de potentiel dont le premier PU1 est formé sous l'électrode de référence ER, et dont le second PU2 est formé sous l'électrode de stockage ES. Le potentiel de commande appliqué à la première électrode de commande EC 1 détermine sous cette dernière une seconde barrière de potentiel BP2, et la seconde électrode de commande EC2 détermine une troisième barrière de potentiel BP3. Ainsi en suivant le sens 4 de transfert des charges, on trouve successivement la seconde barrière de potentiel BP2, puis le premier puits de potentiel PU1 (sous l'électrode de référence), puis la première barrière de potentiel BP1 (sous l'électrode d'entrée IE), puis le second puits de potentiel PU2, et enfin la troisième barrière de potentiel BP3.

Tant que la tension de remise à niveau VN est appliquée au point A à potentiel flottant, le potentiel sous l'électrode de commande IE est à une valeur VN' qui correspond au sommet de la première barrière de potentiel BP1. Le potentiel VN' définit une hauteur H1 à la barrière de potentiel BP1, et cette hauteur H1 représente la profondeur du premier puits de potentiel PU1 ; ceci signifie que la hauteur de la première barrière de potentiel BP1 détermine la quantité de charges susceptibles d'être stockée dans le premier puits de potentiel PU1.

La hauteur H1 de la barrière de potentiel BP1 est liée à la tension de remise à niveau VN qui a une valeur constante. Cependant la hauteur de la barrière de potentiel peut être modulée par un bruit introduit par le transistor de remise à niveau TRN. En vue d'éliminer ce bruit lors de la lecture d'une charge de signal, suivant une caractéristique de l'invention, une quantité de charge égale ou supérieure à la quantité que peut contenir le premier puits de potentiel PU1 est injectée dans ce dernier, juste après l'application de la tension de remise à niveau VN au point A à potentiel flottant et avant le début de la période d'exposition. A cet effet, on peut par exemple commander la première électrode de commande EC1 afin d'abaisser la seconde barrière de potentiel BP2, et permettre de déverser dans le premier puits de potentiel PU1 une quantité de charges produites en amont de la seconde barrière de potentiel BP2, par exemple par la diode d'injection Di montrée à la figure 4. Le premier puits de potentiel PU1 contient alors une quantité de charge de remplissage QR ; et la quantité de charge éventuellement en excédent (non représentée) passe au dessus de la première barrière de potentiel BP1 pour aller dans le second puits de potentiel PU 2, d'où ces charges sont ensuite évacuées, à l'aide par exemple de la diode d'évacuation De montrée à la figure 4, d'une manière en elle-même classique.

Cette opération permet, entre la phase de remise à niveau et la période d'exposition, de remplir le premier puits de potentiel PU1 à une hauteur H1 qui est définie par la barrière de potentiel BP1, et qui tient compte de la valeur du bruit introduit par le transistor de remise à niveau TRN.

A l'instant du début de la période d'exposition à un rayonnement, le point A est un point à potentiel flottant (le transistor de remise à niveau TRN étant non conducteur depuis la phase de remise à niveau). Si des charges sont générées dans la capacité pyroélectrique CP, elles engendrent une variation négative de la tension au point A, variation qui est répercutée dans le substrat semiconducteur 15, sous l'électrode d'entrée IE où le potentiel passe alors à une nouvelle valeur VB plus négative, de telle manière que la barrière de potentiel BP1 comporte alors une seconde hauteur H2 plus grande que la première hauteur H1. Les deux hauteurs H1, H2 contenant chacune une même valeur du bruit introduit par le transistor TRN, la différence de hauteur H2 - H1 est uniquement proportionnelle à la valeur de la charge de signal produite pendant l'exposition.

Une quantité de charge d'entraînement Q0 est alors injectée dans le premier puits de potentiel PU1, par exemple à l'aide de la diode d'injection Di et en commandant la seconde barrière de potentiel BP2 comme dans l'exemple précédent. Suivant une caractéristique de l'invention et suivant une première version du procédé, la charge d'entraînement Q0 a une valeur connue et supérieure à la quantité de charges nécessaire à remplir entièrement le premier puits de potentiel PU1 après la fin de la période d'exposition, c'est-à-dire après que la première barrière de potentiel BP1 ait atteint la seconde hauteur H2. La charge d'entraînement Q0 est séparée en une première et une seconde fraction Qₛ et Q_{c} : la première fraction Qₛ est proportionnelle à la charge de signal, elle reste dans le premier puits de potentiel PU1 pour combler la différence entre la seconde hauteur H2 et la première hauteur H1 ; la seconde fraction Q_{c} est une quantité complémentaire qui est déversée dans le second puits de potentiel PU2 et qui représente le complément nécessaire à la fraction Qₛ pour obtenir la charge d'entraînement Q0. La charge d'entraînement Q0 ayant une valeur connue, il suffit ensuite de transférer vers un circuit de lecture la charge complémentaire Q_{c} contenue dans le second puits de potentiel, pour pouvoir déterminer la valeur de la quantité de charges Qₛ représentant la charge de signal. Il est à noter qu'en outre, une amélioration du rapport signal sur bruit dépend du rapport des capacités entre la capacité pyroélectrique CP et la capacité associée à l'électrode de référence ER, et que cette amélioration est d'autant forte que la capacité associée à l'électrode de référence ER est grande vis-à-vis de la capacité pyroélectrique CP.

Il est possible ensuite d'éliminer toutes les charges contenues dans le premier puits de potentiel PU1, et de débuter un cycle suivant d'une manière semblable à celle ci-dessus expliquée, c'est-à-dire en appliquant à nouveau la tension de remise à niveau VN à l'électrode inférieure EI 9 en rendant conducteur le transistor de remise à niveau TRN.

Mais, il est possible également de confirmer la mesure d'une charge signal par une lecture directe de la quantité de charges Qₛ, quantité de charges Qₛ qui représente la différence de hauteur de la barrière de potentiel BP1. A cet effet, il suffit de laisser au matériau pyroélectrique qui constitue la capacité pyroélectrique CP le temps de recouvrir sa température de départ, c'est-à-dire la température qu'il comportait avant la période d'exposition. En effet, avec le refroidissement de la capacité pyroélectrique CP, le potentiel du point flottant A accuse une variation positive, variation positive qui se traduit par une diminution de la hauteur de la première barrière de potentiel BP1 : avec le refroidissement de la capacité pyroélectrique CP, la hauteur de la barrière de potentiel BP1 diminue et entraîne le déversement progressif dans le second puits de potentiel PS des charges Qₛ précédemment contenues dans le premier puits de potentiel PU1 ; et à la fin du temps de refroidissement de la capacité pyroélectrique CP, toutes les charges de la fraction Qₛ qui est représentative de la différence de hauteur H2 - H1 c'est-à-dire représentative de la charge signal, sont transférées dans le second puits de potentiel PU 2. Il suffit alors de transférer les charges contenues dans le second puits de potentiel PU 2 vers un circuit de lecture pour lire ces charges et connaître leur valeur.

Cependant la quantité de ces charges Qₛ peut être relativement faible et leur lecture peut présenter certaines difficultés. Dans ce cas, de préférence (mais non impérativement) quand le matériau pyroélectrique de la capacité pyroélectrique CP est entièrement refroidi, on peut injecter une seconde charge d'entraînement Q0 dans le premier puits de potentiel PU1. Ce dernier étant déjà entièrement rempli, toute la charge d'entraînement Q0 est déversée dans le second puits de potentiel PU2, où elle s'ajoute à la fraction Qₛ qui représente la charge de signal. On transfère ensuite vers un circuit de lecture (non représenté) toute la quantité de charges contenue dans le second puits de potentiel PU2, quantité de charges qui est constituée par la charge d'entraînement Q0 à laquelle est ajoutée la part de charge Qₛ représentative de la charge de signal.

La lecture de la partie de charge complémentaire Q_{c} opérée à la fin de la période d'exposition peut être mise en mémoire, puis soustraite de la quantité de charge Q0 + Qₛ, de sorte que le résultat de cette soustraction représente deux fois Qₛ, les premières et secondes charges d'entraînement Q0 s'étant annulées. On note que suivant cette seconde méthode, la quantité de charges d'entraînement Q0 n'a pas besoin d'être connue.

## Revendications

1. Détecteur infrarouge de type monolithique, comportant :
- un substrat semiconducteur (15) comprenant un circuit multiplexeur à transfert de charge ;
- une couche de matériau pyroélectrique (11) formée sur le substrat semiconducteur et comprenant une pluralité de zones pyroélectriques (P1 à P9), chaque zone pyroélectrique correspondant à un pixel et comportant une électrode inférieure individuelle (EI1 à EI9) reliée électriquement à un étage d'entrée correspondant (CT1 à CT9) du circuit multiplexeur à transfert de charge ;
- une couche conductrice formant une électrode supérieure (13) portée par la couche de matériau pyroélectrique à l'opposé des électrodes inférieures, l'électrode supérieure étant commune à toutes les zones pyroélectriques ; et
- des moyens de commutation (DP) reliant respectivement les électrodes inférieures au substrat semiconducteur afin de permettre l'établissement d'un courant électrique entre chaque électrode inférieure et le substrat semiconducteur pour polariser la couche de matériau pyroélectrique.

2. Détecteur infrarouge suivant la revendication 1, caractérisé en ce que le matériau pyroélectrique possède une conductivité thermique inférieure à 1W/mK.

3. Détecteur infrarouge suivant l'une des revendications précédentes, caractérisé en ce que chaque moyen de commutation comporte une diode (DP) formée dans le substrat semiconducteur (15) à l'aide d'une zone implantée (22) présentant un type de conductivité opposé à celui du substrat semiconducteur.

4. Détecteur infrarouge selon l'une des revendications précédentes, caractérisé en ce que chaque électrode inférieure (EI 1 à EI 9) est reliée à un transistor (TRN) formant un second moyen de commutation qui permet d'appliquer une tension de remise à niveau (VN) à chaque électrode inférieure.

5. Détecteur infrarouge selon la revendication 4, caractérisé en ce que le transistor (TRN) est réalisé dans le substrat semiconducteur (15) à l'aide de zones implantées dans ce dernier.

6. Détecteur infrarouge selon l'une des revendications 4 ou 5, caractérisé en ce que le circuit multiplexeur à transfert de charge (CT 9) comporte une électrode d'entrée (IE) par zone pyroélectrique, chaque électrode d'entrée (IE) étant reliée à la fois à l'électrode inférieure (EI 9) et à la diode de polarisation (DP) et au transistor (TRN) de commutation, chaque électrode d'entrée servant à former une barrière de potentiel (BP1) dans le substrat semiconducteur (15), cette barrière de potentiel séparant deux puits de potentiel (PU1, PU2) dans le substrat semiconducteur.

7. Procédé de lecture de charges de signal engendrées dans des zones pyroélectriques (P1 à P9) ou pixels dans un détecteur infrarouge selon la revendication 6, chaque zone pyroélectrique (P1 à P9) comportant ladite électrode inférieure (EI 1 à EI 9) dont le potentiel varie proportionnellement aux charges de signal engendrées durant une période d'exposition à un rayonnement du détecteur infrarouge, le procédé consistant à réaliser dans le substrat semiconducteur (15) la barrière de potentiel (BP1) entre le premier et le second puits de potentiel (PU1, PU2), puis à conférer à la barrière de potentiel (BP1) une hauteur (H1, H2) proportionnelle au potentiel de l'électrode inférieure (EI 9), la profondeur du premier puits de potentiel (PU1) étant donnée par la hauteur de la barrière de potentiel, ledit procédé consistant en outre avant la période d'exposition à un rayonnement, à appliquer une tension de remise à niveau (VN) à l'électrode inférieure (EI 9), puis à supprimer l'application de la tension de remise à niveau et à remplir le premier puits de potentiel (PU1), puis à débuter la période d'exposition, puis après la période d'exposition, à injecter une quantité de charges d'entraînement (Q0) dans le premier puits de potentiel de manière à partager la quantité de charge d'entraînement (Q0) en deux fractions (Qₛ , Q_{c}), la première fraction (Qₛ) représentant la charge de signal et étant stockée dans le premier puits de potentiel (PU 1), et la seconde fraction (Q_{c}) étant déversée et stockée dans le second puits de potentiel (PU2) et représentant la différence (Q0 - Qₛ) entre la charge d'entraînement (Q0) et la première fraction (Qₛ).

8. Procédé selon la revendication 7, caractérisé en ce qu'il consiste à transférer vers un circuit de lecture la seconde fraction (Q_{c}) contenue dans le second puits de potentiel (PU2).

9. Procédé selon la revendication 8, caractérisé en ce que la quantité de charges d'entraînement (Q0) a une valeur connue.

10. Procédé selon l'une des revendications 7 ou 9, caractérisé en ce qu'il consiste à laisser refroidir les zones pyroélectriques (P1 à P9) pour leur permettre de recouvrer une même température qu'avant la période d'exposition, de manière que la première fraction de charge (Qₛ) soit déversée dans le second puits de potentiel (PU2), puis à transférer vers un circuit de lecture la première fraction de charge (Qₛ).

11. Procédé selon l'une quelconque des revendications 7 ou 8 ou 9, caractérisé en ce qu'après la période d'exposition il consiste à injecter dans le premier puits de potentiel (PU1) une seconde quantité de charges d'entraînement (Q0), puis après que les zones pyroélectriques (P1 à P9) soient revenues à leur température d'avant la période d'exposition, à transférer vers un circuit de lecture les charges contenues dans le second puits de potentiel (PU2) de manière que les charges ainsi transférées soient constituées par la quantité de charges d'entraînement (Q0), plus la première fraction de charge (Qₛ).

## Patentansprüche

1. Monolithischer Infrarotdetektor mit:
- einem Halbleitersubstrat (15), das eine Ladungsübertragungs-Multiplexerschaltung aufweist;
- einer Schicht (11) aus pyroelektrischem Material, die auf dem Halbleitersubstrat gebildet ist und mehrere pyroelektrische Zonen (P1 bis P9) aufweist, wobei jede pyroelektrische Zone einem Pixel entspricht und eine idividuelle untere Elektrode (EI1 bis EI9) enthält, die mit einer entsprechenden Eingangsstufe (CT1 bis CT9) der Ladungsübertragungs-Multiplexerschaltung elektrisch verbunden ist;
- einer leitenden Schicht, die eine obere Elektrode (13) bildet, die von der Schicht aus pyroelektrischem Material entgegengesetzt zu den unteren Elektroden getragen wird, wobei die obere Elektrode allen pyroelektrischen Zonen gemeinsam ist; und
- Schaltmitteln (DP), die jeweils die unteren Elektroden mit dem Halbleitersubstrat verbinden, um die Ausbildung eines elektrischen Stroms zwischen jeder unteren Elektrode und dem Halbleitersubstrat zur Vorspannung der Schicht aus pyroelektrischem Material zu ermöglichen.

2. Infrarotdetektor nach Anspruch 1, dadurch gekennzeichnet, daß das pyroelektrische Material eine Wärmeleitfähigkeit von weniger als 1W/mK hat.

3. Infrarotdetektor nach einem der vorhergehenden Ansprüche, dadurch gekennzeichnet, daß jedes Schaltmittel eine Diode (DP) enthält, die in dem Halbleitersubstrat (15) mit Hilfe einer implantierten Zone (22) gebildet ist, die einen Leitfähigkeitstyp aufweist, der demjenigen des Halbleitersubstrats entgegengesetzt ist.

4. Infrarotdetektor nach einem der vorhergehenden Ansprüche, dadurch gekennzeichnet, daß jede untere Elektrode (EI1 bis EI9) mit einem Transistor (TRN) verbunden ist, der ein zweites Schaltmittel bildet, das das Anlegen einer Pegelrückstellspannung (VN) an jede untere Elektrode ermöglicht.

5. Infrarotdetektor nach Anspruch 4, dadurch gekennzeichnet, daß der Transistor (TRN) in dem Halbleitersubstrat (15) mit Hilfe von in dieses implantierten Zonen gebildet ist.

6. Infrarotdetektor nach einem der Ansprüche 4 oder 5, dadurch gekennzeichnet, daß die Ladungsübertragungs-Multiplexerschaltung (CT9) eine Eingangselektrode (IE) pro pyroelektrischer Zone aufweist, wobei jede Eingangselektrode (IE) zugleich mit der unteren Elektrode (EI9) und mit der Vorspannungsdiode (DP) und mit dem Schalttransistor (TRN) verbunden ist, wobei jede Eingangselektrode dazu dient, eine Potentialschwelle (BP1) in dem Halbleitersubstrat (15) zu bilden, wobei die Potentialschwelle zwei Potentialtöpfe (PU1, PU2) in dem Halbleitersubstrat voneinander trennt.

7. Verfahren zum Lesen von Signalladungen, die in pyroelektrischen Zonen (P1 bis P9) oder Pixeln in einem Infrarotdetektor nach Anspruch 6 erzeugt worden sind, wobei jede pyroelektrische Zone (P1 bis P9) die untere Elektrode (EI1 bis EI9) enthält, deren Potential sich proportional zu den Signalladungen ändert, die während einer Periode der Belichtung des Infrarotdetektors durch eine Strahlung erzeugt werden, wobei das Verfahren darin besteht, daß in dem Halbleitersubstrat (15) die Potentialschwelle (BP1) zwischen dem ersten und dem zweiten Potentialtopf (PU1, PU2) erzeugt wird, dann der Potentialschwelle (BP1) eine Höhe (H1, H2) erteilt wird, die zu dem Potential der unteren Elektrode (EI9) proportional ist, wobei die Tiefe des ersten Potentialtopfs (PU1) durch die Höhe der Potentialschwelle gegeben ist, wobei das Verfahren ferner darin besteht, daß vor der Periode der Belichtung mit einer Strahlung eine Pegelrückstellspannung (VN) an die untere Elektrode (EI9) angelegt wird, dann das Anlegen der Pegelrückstellspannung unterdrückt wird und der erste Potentialtopf (PU1) gefüllt wird, dann die Belichtungsperiode begonnen wird, dann nach der Belichtungsperiode eine Eintragsladungsmenge (Q0) in den ersten Potentialtopf derart injiziert wird, daß die Eintragsladungsmenge (Q0) in zwei Teilmengen (Qₛ, Q_{c}) aufgeteilt wird, wobei die erste Teilmenge (Qₛ) die Sinalladung darstellt und in dem ersten Potentialtopf (PU1) gespeichert wird, und die zweite Teilmenge (Q_{c}) abgeleitet und in dem zweiten Potentialtopf (PU2) gespeichert wird und die Differenz (Q0-Qₛ) zwischen der Eintragsladungsmenge (Q0) und der ersten Teilmenge (Qₛ) darstellt.

8. Verfahren nach Anspruch 7, dadurch gekennzeichnet, daß es darin besteht, die in dem zweiten Ladungstopf (PU2) enthaltene zweite Teilmenge (Q_{c}) zu einer Leseschaltung zu übertragen.

9. Verfahren nach Anspruch 8, dadurch gekennzeichnet, daß die Eintragsladungsmenge (Q0) einen bekannten Wert hat.

10. Verfahren nach einem der Ansprüche 7 oder 9, dadurch gekennzeichnet, daß es darin besteht, die pyroelektrischen Zonen (P1 bis P9) abkühlen zu lassen, damit sie eine gleiche Temperatur wie vor der Belichtungsperiode annehmen können, so daß die erste Ladungsteilmenge (Qₛ) in den zweiten Potentialtopf (PU2) abgeleitet wird, und dann die erste Ladungsteilmenge (Qₛ) zu einer Leseschaltung zu übertragen.

11. Verfahren nach einem der Ansprüche 7 oder 8 oder 9, dadurch gekennzeichnet, daß es nach der Belichtungsperiode darin besteht, in den ersten Potentialtopf (PU1) eine zweite Eintragsladungsmenge (Q0) zu injizieren, dann, nachdem die pyroelektrischen Zonen (P1 bis P9) auf ihre Temperatur vor der Belichtungsperiode zurückgekehrt sind, die in dem zweiten Potentialtopf (PU2) enthaltenen Ladungen zu einer Leseschaltung zu übertragen, so daß die derart übertragenen Ladungen durch die Eintragsladungsmenge (Q0) plus der ersten Ladungsteilmenge (Qₛ) gebildet sind.

## Claims

1. Infrared detector of monolithic type, including:
- a semiconductive substrate (15) comprising a charge-coupled multiplexer circuit;
- a pyroelectric material layer (11) formed on the semiconductive substrate and comprising a plurality of pyroelectric zones (P1 to P9), each pyroelectric zone corresponding to a pixel and including an individual lower electrode (EI1 to EI9) electrically connected to a corresponding input stage (CT1 to CT9) of the charge-coupled multiplexer circuit;
- a conductive layer forming an upper electrode (13) carried by the pyroelectric material layer, opposite the lower electrodes, the upper electrode being common to all the pyroelectric zones; and
- switching means (DP) respectively connecting the lower electrodes to the semiconductive substrate so as to allow the establishment of an electric current between each lower electrode and the semiconductive substrate in order to polarize the pyroelectric material layer.

2. Infrared detector according to Claim 1, characterized in that the pyroelectric material possesses a thermal conductivity of less than 1 W/mK.

3. Infrared detector according to one of the preceding claims, characterized in that each switching means includes a diode (DP) formed in the semiconductive substrate (15) with the aid of an implanted zone (22) exhibiting a conductivity type opposite to that of the semiconductive substrate.

4. Infrared detector according to one of the preceding claims, characterized in that each lower electrode (EI1 to EI9) is connected to a transistor (TRN) forming a second switching means which makes it possible to apply a reset-to-level voltage (VN) to each lower electrode.

5. Infrared detector according to Claim 4, characterized in that the transistor (TRN) is made in the semiconductive substrate (15) with the aid of zones implanted in the latter.

6. Infrared detector according to one of Claims 4 or 5, characterized in that the charge-coupled multiplexer circuit (CT9) includes one input electrode (IE) per pyroelectric zone, each input electrode (IE) being connected simultaneously to the lower electrode (EI9) and to the polarizing diode (DP) and to the switching transistor (TRN), each input electrode serving to form a potential barrier (BP1) in the semiconductive substrate (15), this potential barrier separating two potential wells (PU1, PU2) in the semiconductive substrate.

7. Process for reading signal charges engendered in pyroelectric zones (P1 to P9) or pixels in an infrared detector according to Claim 6, each pyroelectric zone (P1 to P9) including the said lower electrode (EI1 to EI9) whose potential varies in proportion to the signal charges engendered during a period of exposure to radiation of the infrared detector, the process consisting in producing in the semiconductive substrate (15) the potential barrier (BP1) between the first and the second potential wells (PU1, PU2), in then imparting to the potential barrier (BP1) a height (H1, H2) proportional to the potential of the lower electrode (EI9), the depth of the first potential well (PU1) being given by the height of the potential barrier, the said process consisting furthermore before the period of exposure to radiation, in applying a reset-to-level voltage (VN) to the lower electrode (EI9), in then removing the application of the reset-to-level voltage and in filling the first potential well (PU1), in then beginning the period of exposure, then after the period of exposure, in injecting an amount of driving charge (Q0) into the first potential well so as to divide up the amount of drive charge (Q0) into two fractions (Qₛ, Q_{c}), the first fraction (Qₛ) representing the signal charge and being stored in the first potential well (PU1), and the second fraction (Q_{c}) being spilled and stored in the second potential well (PU2) and representing the difference (Q0-Qₛ) between the drive charge (Q0) and the first fraction (Qₛ).

8. Process according to Claim 7, characterized in that it consists in transferring the second fraction (Q_{c}) contained in the second potential well (PU2) to a read circuit.

9. Process according to Claim 8, characterized in that the amount of drive charge (Q0) has a known value.

10. Process according to one of Claims 7 or 9, characterized in that it consists in leaving the pyroelectric zones (P1 to P9) to cool so as to allow them to recover the same temperature as before the period of exposure, so that the first charge fraction (Qₛ) is spilled into the second potential well (PU2), and in then transferring the first charge fraction (Qₛ) to a read circuit.

11. Process according to any one of Claims 7 or 8 or 9, characterized in that after the period of exposure it consists in injecting a second amount of drive charge (Q0) into the first potential well (PU1), then after the pyroelectric zones (P1 to P9) have returned to their temperature before the period of exposure, in transferring the charge contained in the second potential well (PU2) to a read circuit so that the charge thus transferred consists of the amount of drive charge (Q0) plus the first charge fraction (Qₛ).
